# EUROPÄISCHE PATENTSCHRIFT

(11) **EP 3 564 015 B1**
(45) Veröffentlichungstag und Bekanntmachung des Hinweises auf die Patenterteilung: **05.01.2022**
(21) Anmeldenummer: 19171504.4
(22) Anmeldetag: 29.04.2019
(51) Int. Cl.: B29C 70/54, G01L 1/06, G01L 1/14, G01M 5/00, G01N 27/20, H01L 41/113, H01L 41/193

(54) **STRUKTURBAUTEIL SOWIE SYSTEM UND VERFAHREN ZUR DETEKTION VON BESCHÄDIGUNGEN**
STRUCTURAL COMPONENT AND SYSTEM AND METHOD FOR DETECTING DAMAGE
COMPOSANT STRUCTURAL AINSI QUE SYSTÈME ET PROCÉDÉ DE DÉTECTION DE DOMMAGES

(30) Priorität: 30.04.2018 DE 102018206665
(43) Veröffentlichungstag der Anmeldung: 06.11.2019
(73) Patentinhaber: Airbus Operations GmbH, 21129 Hamburg (DE)
(72) Erfinder: LINDE, Peter, 21129 Hamburg (DE)
(74) Vertreter: Isarpatent

(56) Entgegenhaltungen:
- EP-A1- 3 175 979
- WO-A1-2016/156175
- DE-A1-102015 218 891
- US-A1- 2011 241 704

## Beschreibung

Die vorliegende Erfindung betrifft ein Strukturbauteil, ein System zur Detektion von Beschädigungen, ein Luftfahrzeug mit einem solchen System sowie ein Verfahren zur Detektion von Beschädigungen eines Strukturbauteils.

Faserverbundmaterialen bieten große Vorteile hinsichtlich Gewicht und Festigkeit. In der Regel weisen aus Faserverbundmaterialen hergestellte Strukturbauteile einen Schichtaufbau auf, wobei mehrere Faserverbundlagen in Stapelbauweise und stoffschlüssig miteinander verbunden vorgesehen sind. Solche Bauteile werden häufig in Luftfahrzeugen eingesetzt, beispielsweise als Stringer, Spanten, Hautsegmente oder ähnliches.

Bei dem schichtartigen Aufbau ist es wichtig, dass eine lokale Trennung oder Ablösung der einzelnen Schichten voneinander, was als Delamination bezeichnet wird, zuverlässig vermieden wird.

Um die mechanischen Eigenschaften eines Strukturbauteils zu überprüfen, wird in der US 7,246,521 B2 beschrieben, eine Vielzahl von Piezoelementen an dem Strukturbauteil zu befestigen, wobei die Piezoelemente zur Anregung und Erfassung von Schwingungen vorgesehen sind. Aus einem erfassten Schwingungsverlauf kann auf Schäden des Bauteils geschlossen werden. Solche Systeme werden auch als Health Monitoring Systeme bezeichnet.

In der US 2012/0265449 A1 wird ebenfalls ein Health Monitoring System für ein Faserverbundbauteil beschrieben, bei welchem Sensoren zwischen zwei Lagen des Bauteils angeordnet sind, um die Integrität einer die Lagen verbindenden Klebstoffschicht zu erfassen.

Die US 2007/0166831 A1 beschreibt ein Faserverbundbauteil, an dessen Oberfläche ein resistiver Sensor durch eine lokale Einbringung von elektrisch leitenden Partikeln in ein Matrixmaterial ausgebildet ist. Durch Erfassen einer Änderung des elektrischen Widerstands des Sensors kann auf das Vorliegen einer Beschädigung des Bauteils geschlossen werden.

Es ist Aufgabe der vorliegenden Erfindung, die bekannten Konzepte zur Detektion von Schäden an einem Faserverbundbauteil weiter zu entwickeln.

Diese Aufgabe wird jeweils durch die Gegenstände der unabhängigen Ansprüche gelöst.

Vorteilhafte Ausgestaltungen und Weiterbildungen ergeben sich aus den auf die unabhängigen Ansprüche rückbezogenen Unteransprüchen in Verbindung mit der Beschreibung.

Nach einem ersten Aspekt der Erfindung ist ein Strukturbauteil nach Anspruch 1 vorgesehen. Das erfindungsgemäße Strukturbauteil weist eine Vielzahl von Materiallagen auf, die in einer Dickenrichtung gestapelt angeordnet und miteinander verbunden sind, wobei zumindest eine der Materiallagen eine Faserverbundschicht aus einem Faserverbundmaterial ist, welche durch Faserbänder realisiert ist; wobei eine in Bezug auf die Dickenrichtung (D) äußerste Materiallage zumindest abschnittsweise durch eine Sensoreinrichtung ausgebildet ist, welche mehrere nebeneinander angeordnete bandförmige Sensoreinheiten aufweist, wobei je eine Sensoreinheit ein zwischen elektrisch leitfähigen Elektroden angeordnetes elektroaktives Polymer aufweist.

Ein der vorliegenden Erfindung zugrundeliegender Gedanke besteht demnach darin, eine Deckschicht eines mehrere Lagen umfassenden Faserverbundbauteils zumindest bereichsweise als Sensorschicht durch mehrere ein elektroaktives Polymermaterial (kurz EAP) aufweisende Sensoreinheiten auszubilden. EAPs sind Polymermaterialien, die durch das Anlegen einer elektrischen Spannung ihre Form ändern. Umgekehrt sind EAPs auch in der Lage bei Verformung einen elektrischen Potenzialunterschied zu erzeugen. Diese Eigenschaften macht sich die vorliegende Erfindung zu Nutze, indem eine äußerste Schicht eines Faserverbundbauteils, das eine oder mehrere Faserverbundlagen aufweist, mit einer Sensoreinrichtung versehen wird, welche mehrere Sensoreinheiten mit einem zwischen zwei Elektroden angeordneten EAP-Material aufweist. Die Sensoreinheit ist also nach Art eines Kondensators aufgebaut. Bei Verformung des Strukturbauteils wird die Sensoreinheit ebenfalls verformt und es kann aufgrund der Eigenschaften des EAP-Materials eine Änderung der elektrischen Spannung an den Elektroden erfasst werden. Im Falle einer Delamination des Bereichs der äußersten Schicht, der durch die Sensoreinheit gebildet ist, ändert sich auch der Verformungszustand der Sensoreinheit und damit die elektrische Spannung an den Elektroden, wodurch die Delamination detektierbar ist.

Da die Sensoreinrichtung einen Teil der äußersten Schicht bzw. der Deckschicht des Strukturbauteils ausbildet, also gleichzeitig einen Teil der Oberfläche des Strukturbauteils bildet, wird eine vollständige strukturelle Integration der Sensoreinrichtung in das Bauteil erzielt. Dies ist hinsichtlich der mechanischen Stabilität des Strukturbauteils vorteilhaft, da EAP-Materialien eine vergleichbare mechanische Festigkeit aufweisen, wie die Faserverbundlagen. Ferner ist es durch die Integration der Sensoreinrichtung in den Schichtaufbau als Teil der äußersten Materialschicht nicht erforderlich Sensoren als gesonderte, zusätzliche Komponenten an einen vollständigen Schichtaufbau anzubringen. Dies spart Gewicht und Bauraum und reduziert auch den Fertigungsaufwand.

Da EAP-Materialen, wie oben beschrieben, bei Verformung einen elektrischen Potenzialunterschied erzeugen, ist eine Erzeugung von Messsignalen durch die Sensoreinheiten der Sensoreinrichtung ohne elektrische Spannungsversorgung möglich. Insbesondere wird eine elektrische Spannungsquelle zur Versorgung der Sensoreinrichtung nicht zwingend benötigt. Dies spart zusätzliches Gewicht ein. Darüber hinaus ist die Erfassung nicht vom Betriebszustand einer elektrischen Versorgung abhängig, wodurch die Zuverlässigkeit der Sensoreinrichtung verbessert wird.

Gemäß einer Ausführungsform des Strukturbauteils bildet die Sensoreinrichtung die äußerste Materiallage des Strukturbauteils vollflächig aus. Es kann also die gesamte Deckschicht des Strukturbauteils als Sensoreinrichtung ausgebildet sein. Da somit über die gesamte flächige Erstreckung der Deckschicht durch mehrere Sensoreinheiten vorhanden sind, kann eine Delamination oder Beschädigung des Strukturbauteils unabhängig davon erfasst werden, wo diese in Bezug auf die flächige Erstreckung auftritt. Dies verbessert weiter die Zuverlässigkeit, mit der eine Delamination erfasst oder detektiert werden kann.

Erfindungsgemäß sind die Sensoreinheiten bandförmig ausgebildet. Das heißt, eine Sensoreinheit weist eine Erstreckung in einer Längsrichtung (Längserstreckung) auf, die deutlich größer ist, als eine Erstreckung der Sensoreinheit in einer quer zur Längsrichtung verlaufenden Breitenrichtung (Breitenerstreckung). Beispielsweise kann die Längserstreckung zumindest das zweifache, insbesondere zumindest das fünffache und vorzugsweise zumindest das zehnfache der Breitenerstreckung betragen. Der bandförmige Aufbau der Sensoreinheit als Sensorband bietet den Vorteil, dass die Sensoreinheit mittels eines Ablegekopfes, wie er zum Ablegen von Faserbändern zur Erzeugung der Faserverbundschichten des Strukturbauteils üblich ist, auf bereits gestapelte Materiallagen des Strukturbauteils abgelegt werden kann. Damit wird die Herstellung des Strukturbauteils vereinfacht. Ein weiterer Vorteil besteht darin, dass eine Vielzahl von Sensorbändern nebeneinander angeordnet sind, wodurch eine Beschädigung, wie z.B. eine Delamination ortsaufgelöst detektierbar ist.

Gemäß einer weiteren Ausführungsform des Strukturbauteils ist zusätzlich zu der äußersten Materiallage auch eine sich in der Dickenrichtung unmittelbar an die äußerste Materiallage anschließende erste innere Materiallage zumindest abschnittsweise durch die Sensoreinrichtung ausgebildet. Die erste innere Materiallage ist also direkt mit der äußersten Materiallage verbunden. Die zumindest teilweise Ausbildung der zwei äußersten Materiallagen als Sensoreinheit erhöht weiter die Zuverlässigkeit der Detektion von Beschädigungen des Strukturbauteils.

Optional ist in der ersten inneren Materiallage zumindest eine Sensoreinheit vorgesehen. Vorzugsweise sind die in der äußersten Materiallage und die in der ersten inneren Materiallage angeordneten Sensoreinheiten jeweils bandförmig ausgebildet und erstrecken sich quer zueinander. Hierbei ist also in der äußersten Materialschicht zumindest ein erstes Sensorband als Sensoreinheit vorgesehen, das sich in einer ersten Richtung erstreckt, und in der sich anschließenden ersten inneren Materialschicht ist zumindest ein zweites Sensorband als Sensoreinheit vorgesehen, das sich in einer zweiten Richtung erstreckt, wobei die erste und die zweite Richtung quer zueinander verlaufen. Dadurch ergeben sich bei Verformung des Strukturbauteils abhängig von der Verformungsrichtung verschiedene Potenzialunterschiede an den Elektroden des ersten und des zweiten Sensorbands. Somit lassen sich detektierte Beschädigungen einer bestimmten Verformungsrichtung zuordnen. Ferner wird die Ortsauflösung einer Beschädigung weiter verbessert und durch Vergleich der erfassten Spannungen an den Elektroden kann eine Überprüfung der Funktionsfähigkeit der einzelnen Sensoreinheiten auf einfache Weise erfolgen. Somit wird die Zuverlässigkeit der Beschädigungserfassung weiter verbessert.

Gemäß einer weiteren Ausführungsform des Strukturbauteils ist das elektroaktive Polymer ein dielektrisches elektroaktives Polymer, insbesondere ein thermoplastisches Polyurethan-Elastomer, wie z.B. der als Epurex LPT 4207 CU-T bezeichnete Werkstoff.

Gemäß einer weiteren Ausführungsform sind die Elektroden der Sensoreinheit aus einem elektrisch leitfähigen Polymer gebildet, insbesondere aus einem Poly-3,4-ethylendioxythiophen poly(3,4-ethylenedioxythiophene)/polystyrene sulfonate Material. Abgekürzt kann dieses Material als PEDOT/PSS bezeichnet werden. Poly-3,4-ethylendioxythiophen poly(3,4-ethylenedioxythiophene) ist aus 2,5-verknüpften 3,4-Ethylendioxythiophen-Einheiten (EDOT) hergestellt. PEDOT/PSS wird über die Oxidation von EDOT durch katalytische Mengen an Eisen(III)-sulfat in Wasser dargestellt.

Gemäß einem weiteren Aspekt der Erfindung ist ein System zur Detektion von Beschädigungen vorgesehen, welches ein Strukturbauteil gemäß einer der voranstehen beschriebenen Ausführungsformen und Spannungsmesseinrichtungen, wobei je eine Spannungsmesseinrichtung an die Elektroden jeweils einer Sensoreinheit angeschlossen ist,

um eine zwischen den Elektroden vorliegende elektrische Spannung zu messen.

Gemäß diesem System bildet die Sensoreinheit einen Teil eines geschossenen Stromkreises, wobei mittels der Spannungsmesseinrichtung eine sich infolge Verformung des EAP Materials zwischen den Elektroden einstellende Spannung durch die Spannungsmesseinrichtung abgegriffen wird.

Gemäß einer Ausführungsform des Systems ist eine der Anzahl der Sensoreinheiten entsprechende Anzahl von Spannungsmesseinrichtungen vorgesehen und je eine Spannungsmesseinrichtung ist an die Elektroden jeweils einer Sensoreinheit angeschlossen. Damit ist die an jeder Sensoreinheit erzeugte Spannung individuell erfassbar, wodurch die Zuverlässigkeit des Systems weiter verbessert wird.

Gemäß einer weiteren Ausführungsform des Systems ist an dem Strukturbauteil zusätzlich eine Verformungserfassungseinrichtung zur Erfassung einer Verformung des Strukturbauteils angeordnet, beispielsweise in Form eines Dehnmessstreifens (DMS). Die Erfassung der mechanischen Verformung des Strukturbauteils erleichtert die Zuordnung einer erfassten Spannungsänderung an den Elektroden der Sensoreinrichtung zu einer Delamination, da durch Vergleich eines Verlaufs einer Spannungsänderung mit einem Verlauf einer Verformung erkennbar ist, ob die Spannungsänderung von einer Änderung der Verformung oder einer Delamination herrührt.

Gemäß einem weiteren Aspekt der Erfindung ist ein Luftfahrzeug mit einem System nach einer der voranstehend beschriebenen Ausführungsformen vorgesehen. Das Strukturbauteils kann hierbei insbesondere als ein Spant oder ein Stringer, insbesondere also als ein Profilträger, oder als ein Hautsegment des Luftfahrzeugs ausgebildet sein. Allgemein kann das Strukturbauteil ein Rumpfbauteil des Luftfahrzeugs bilden.

Gemäß einem weiteren Aspekt der Erfindung ist ein Verfahren zur Detektion von Beschädigungen eines Strukturbauteils nach Anspruch 12 vorgesehen. Erfindungsgemäß werden hierbei bei einem Strukturbauteil, das gemäß einer der voranstehend beschriebenen Ausführungsformen ausgebildet ist, Scherkräfte entlang von Grenzflächen der Materiallagen durch mechanisches Verformen des Strukturbauteils erzeugt. Dies umfasst ein Beaufschlagung des Strukturbauteils mit einer Kraft oder einem Moment. Durch die Verformung werden Scherspannungen entlang der Kontaktflächen benachbarter, miteinander verbundener Materiallagen erzeugt. Weiterhin erfolgt ein Erfassen einer elektrischen Spannung an den Elektroden der Sensoreinheiten der Sensoreinrichtung über einen vorbestimmten Zeitraum und eine Analyse eines sich über den vorbestimmten Zeitraum ergebenden Verlaufs der elektrischen Spannung auf das Vorliegen eines eine Beschädigung kennzeichnenden Beschädigungskriteriums.

Gemäß diesem Verfahren wird also die durch die Verformung des EAP Materials der Sensoreinheiten erzeugte Spannung erfasst und der sich über einen gewissen Zeitraum ergebende Spannungsverlauf analysiert, um auf eine Beschädigung des Bauteils zu schließen. Beispielsweise kann während des gesamten Fluges eines Luftfahrzeugs der Spannungsverlauf erfasst werden. Falls eine Delamination der Sensoreinrichtung von der darunterliegenden Materiallage auftritt, ist dies als Änderung des Spannungsverlaufs sichtbar. Die Analyse umfasst somit die Erkennung eines Verlaufsmusters in dem Spannungsverlauf als Beschädigungskriterium und kann beispielsweise mit Hilfe einer Auswertungssoftware erfolgen.

Gemäß einer Weiterbildung des Verfahrens ist das Beschädigungskriterium bei Vorliegen eines der folgenden Verlaufsmuster des Spannungsverlaufs erfüllt:
a) einer Änderung des Spannungsverlaufs,
b) einer Änderung des Spannungsverlaufs im Vergleich zu einem über den vorbestimmten Zeitraum erfassten Verlauf einer Verformung des Strukturbauteils,
c) einer Abweichung des Spannungsverlaufs in einem ersten Teilzeitraum des vorbestimmten Zeitraums von dem Spannungsverlauf in einem zweiten, späteren Teilzeitraum des vorbestimmten Zeitraums.

Wird eines oder mehrere dieser Verlaufsmuster detektiert, ist das Beschädigungskriterium erfüllt und es wird festgestellt, dass eine Beschädigung des Strukturbauteils vorliegt. Das obige Kriterium a) eignet sich insbesondere bei der Anwendung in Materialversuchen, in welchen das Strukturbauteil solange in einer Richtung verformt wird, bis eine Delamination stattfindet. Kriterium b) bietet den Vorteil, dass direkt feststellbar ist, ob eine Spannungsänderung auf einen Rückgang der Verformung, welche mit einer Verformungsmesseinrichtung wie einem DMS erfasst wird, zurückzuführen ist oder auf eine Delamination. Dies ist insbesondere von Vorteil, wenn längere Zeiträume ausgewertet werden sollen, in denen das Strukturbauteil wechselnden Verformungszuständen unterzogen wird, wie beispielsweise während eines Fluges eines Luftfahrzeugs. Das Kriterium kann rechentechnisch beispielsweise mit sehr geringem Aufwand durch einen Vergleich der Vorzeichen eines zeitlichen Verformungsgradienten und eines zeitlichen Spannungsgradienten ermittelt werden. Kriterium c) bietet wie Kriterium b) den Vorteil, dass längere Zeiträume zuverlässig auswertbar sind. Kriterium c) ist Erfüllt, wenn sich bei gleichen Verformungsverläufen unterschiedliche Spannungsverläufe ergeben. Dies ist besonders vorteilhaft bei periodisch auftretenden Verformungen nutzbar. Nach einer Delamination ist das Verformungsverhalten der Sensoreinheit und damit die abgegriffene Spannung bei einer wiederholten, gleichen Verformung des Strukturbauteils verändert, was als Kriterium für eine Beschädigung herangezogen werden kann.

In Bezug auf Richtungsangaben und Achsen, insbesondere auf Richtungsangaben und Achsen, die den Verlauf von physischen Strukturen betreffen, wird hierin unter einem Verlauf einer Achse, einer Richtung oder einer Struktur "entlang" einer anderen Achse, Richtung oder Struktur verstanden, dass diese, insbesondere die sich in einer jeweiligen Stelle der Strukturen ergebenden Tangenten jeweils in einem Winkel von kleiner 45 Grad, bevorzugt kleiner 30 Grad und insbesondere bevorzugt parallel zueinander verlaufen.

In Bezug auf Richtungsangaben und Achsen, insbesondere auf Richtungsangaben und Achsen, die den Verlauf von physischen Strukturen betreffen, wird hierin unter einem Verlauf einer Achse, einer Richtung oder einer Struktur "quer" zu einer anderen Achse, Richtung oder Struktur verstanden, dass diese, insbesondere die sich in einer jeweiligen Stelle der Strukturen ergebenden Tangenten jeweils in einem Winkel von größer oder gleich 45 Grad, bevorzugt größer oder gleich 60 Grad und insbesondere bevorzugt senkrecht zueinander verlaufen.

Hierin wird unter einem "Faserwerkstoff", einem "Fasermaterial", einem "Faserverbundmaterial" oder einem "Faserverbundwerkstoff" allgemein ein Werkstoff verstanden, der aus einer Vielzahl von insbesondere fadenförmigen oder fadenstückförmigen Verstärkungsfasern, wie beispielsweise Kohle-, Glas-, Keramik-, Aramid-, Bor-, Mineral-, Natur- oder Kunststofffasern oder Mischungen aus diesen gebildet ist. Der Faserwerkstoff kann insbesondere auch mit einem Harz- oder Matrixmaterial wie z.B. einem duroplastischen, thermoplastischen, elastomeren Harz oder allgemein ein Kunststoffharz oder dergleichen imprägniert sein.

Im Folgenden wird die Erfindung unter Bezugnahme auf die Figuren der Zeichnungen erläutert. Von den Figuren zeigen:
- Fig. 1: eine perspektivische Ansicht eines Strukturbauteils, das nicht Teil der Erfindung ist;
- Fig. 2: eine schematische Ansicht eines Systems zur Detektion von Beschädigungen gemäß einem Ausführungsbeispiel der vorliegenden Erfindung, wobei sich ein Strukturbauteil des Systems in einem ersten Verformungszustand befindet;
- Fig. 3: ein Diagramm, das schematisch einen mittels einer Sensoreinrichtung eines Strukturbauteils gemäß der vorliegenden Erfindung erzeugten zeitlichen Spannungsverlauf und einen zeitlichen Verformungsverlauf eines Strukturbauteils gemäß der vorliegenden Erfindung zeigt;
- Fig. 4: eine schematische Ansicht des Systems gemäß Fig. 2, wobei sich das Strukturbauteil des Systems in einem zweiten Verformungszustand befindet, in welchem eine Delamination einer äußersten Materiallage des Strukturbauteils vorliegt;
- Fig. 5: ein Diagramm, das schematisch einen mittels der Sensoreinrichtung des Strukturbauteils gemäß der vorliegenden Erfindung erzeugten zeitlichen Spannungsverlauf und einen zeitlichen Verformungsverlauf eines Strukturbauteils gemäß der vorliegenden Erfindung zeigt, wobei in dem gezeigten Spannungsverlauf ein Beschädigungskriterium erfüllt ist;
- Fig. 6: eine Sensoreinheit einer Sensoreinrichtung eines Strukturbauteils gemäß einem Ausführungsbeispiel der vorliegenden Erfindung;
- Fig. 7: eine perspektivische Ansicht eines Strukturbauteils, das nicht Teil der Erfindung ist;
- Fig. 8: eine Draufsicht auf eine äußerste Materiallage eines Strukturbauteils gemäß einem weiteren Ausführungsbeispiel der vorliegenden Erfindung;
- Fig. 9: eine perspektivische Ansicht eines Strukturbauteils gemäß einem Ausführungsbeispiel der vorliegenden Erfindung; und
- Fig. 10: schematische Ansicht eines Luftfahrzeugs gemäß einem Ausführungsbeispiel der vorliegenden Erfindung.

In den Figuren bezeichnen dieselben Bezugszeichen gleiche oder funktionsgleiche Komponenten, soweit nichts Gegenteiliges angegeben ist.

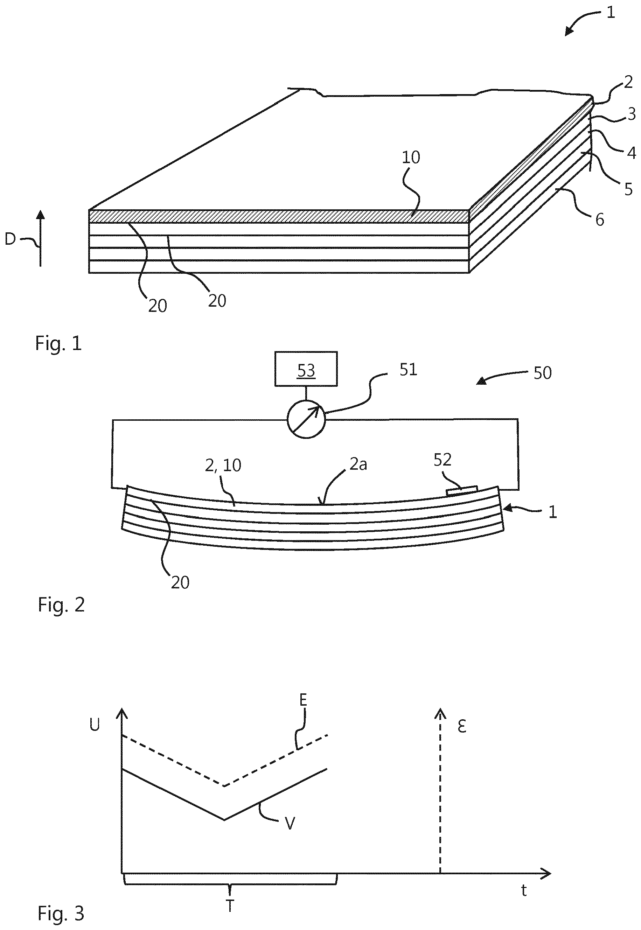

Fig. 1 zeigt schematisch ein Strukturbauteil 1. Das Strukturbauteil 1 weist eine Vielzahl von Materiallagen 2, 3, 4, 5, 6 auf. Die Materiallagen oder -schichten 2, 3, 4, 5, 6 sind jeweils als sich flächig erstreckende Matten oder Bänder realisiert, welche flächig aneinander anliegen bzw. in einer Dickenrichtung D, die quer zur flächigen Erstreckung der Materiallagen 2, 3, 4, 5, 6 verläuft, gestapelt angeordnet sind. Die Materiallagen 2, 3, 4, 5, 6, insbesondere jeweils zwei unmittelbar aufeinander folgende Materiallagen, sind miteinander verbunden, beispielsweise verklebt oder allgemein stoffschlüssig miteinander verbunden. Insbesondere stehen jeweils zwei benachbarte Materiallagen 2, 3, 4, 5, 6 an jeweils einer Grenzflächen 20 miteinander in Kontakt. Eine oder mehrere der Materiallagen 3, 4, 5, 6 sind durch ein Faserverbundmaterial ausgebildet. In Fig. 1 sind beispielsweise die Materiallagen 3, 4, 5 und 6 als Faserverbundlagen ausgebildet und durch eine stoffschlüssige Verbindung eines Matrixmaterials, welches Verstärkungsfasern der jeweiligen Materiallage umgibt, untereinander verbunden.

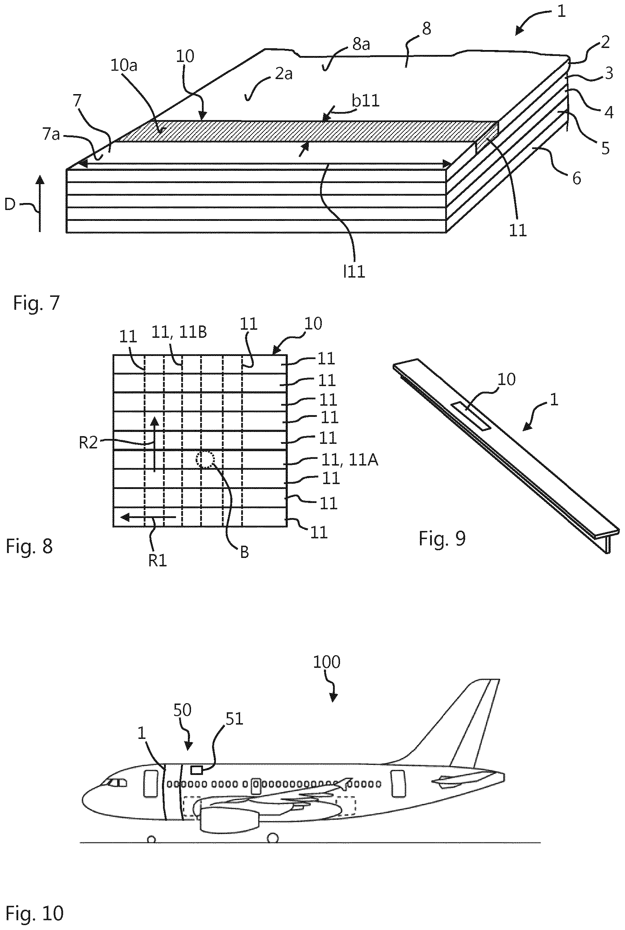

Wie in Fig. 1 weiterhin gezeigt ist, ist eine in Bezug auf die Dickenrichtung D äußerste Materiallage 2, welche auch als erste Deckschicht bezeichnet werden kann, als eine Sensoreinrichtung 10 ausgebildet. Alternativ oder zusätzlich kann auch die in Bezug auf die Dickenrichtung D entgegengesetzt zu der ersten Deckschicht 2 gelegene äußerste Materiallage 6 als Sensoreinrichtung 10 ausgebildet sein oder diese aufweisen. Die Materiallage 6 bildet eine zweite Deckschicht. In Fig. 1 ist beispielhaft gezeigt, dass die gesamte äußerste Materiallage 2 durch die Sensoreinrichtung 10 gebildet ist. Alternativ hierzu kann auch lediglich ein Teilbereich der äußersten Materiallage 2 durch die Sensoreinrichtung 10 gebildet sein, wie dies beispielhaft in den Fig. 7 und 9 gezeigt ist. Allgemein ist die äußerste Materiallage 2 zumindest bereichsweise durch eine Sensoreinrichtung 10 gebildet.

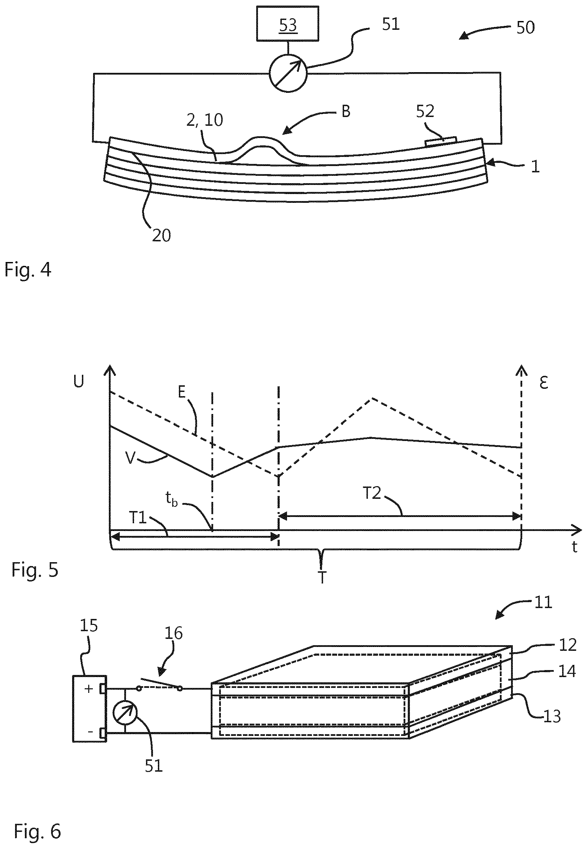

Die Sensoreinrichtung 10 gemäß der vorliegenden Erfindung weist mehrere Sensoreinheiten 11 11 auf. Fig. 6 zeigt schematisch den Aufbau der Sensoreinheit 11. Wie in Fig. 6 erkennbar, weist die Sensoreinheit 11 eine erste Elektrode 12, eine zweite Elektrode 13 und elektroaktives Polymermaterial 14, kurz EAP 14, auf. Wie in Fig. 6 gezeigt, sind die Elektroden 12, 13 als sich flächig erstreckende, plattenförmige Komponenten realisiert. Das EAP 14 ist in Bezug auf die flächige Erstreckung der Elektroden 12, 13 zwischen diesen angeordnet. Das EAP 14 kann insbesondere ein dielektrisches elektroaktives Polymer sein, vorzugsweise ein thermoplastisches Polyurethan-Elastomer. Die Elektroden 12, 13 können beispielsweise aus einem elektrisch leitfähigen Polymer gebildet sein.

Zur Erläuterung des Funktionsprinzips der Sensoreinheit 11 ist in Fig. 6 eine elektrische Spannungsquelle 15 dargestellt, deren Pole über einen Schalter 16 mit den Elektroden 12, 13 verbindbar sind. Wird an die Elektroden 12, 13 eine elektrische Spannung U angelegt, also der Schalter 16 wie in Fig. 6 gestrichelt dargestellt geschlossen, erfolgt eine Verringerung des Abstands der Elektroden 12, 13 und eine Kontraktion des EAP 14. Dieser Zusammenhang zwischen der an den Elektroden 12, 13 anliegenden Spannung U und der Kontraktion kann zur Erfassung einer Beschädigung B genutzt werden, da eine Kontraktion des EAP 14 zu einer Änderung der zwischen den Elektroden 12, 13 abgreifbaren Spannung U führt. Dies wird im Folgenden noch im Detail erläutert.

Wie bereits angesprochen und in Fig. 1 beispielhaft dargestellt, kann die Sensoreinrichtung 10 die äußerste Materiallage 2 insgesamt bzw. vollflächig ausbilden. Fig. 7 zeigt beispielhaft, dass zumindest ein Teilbereich der äußersten Materiallage 2 als Sensoreinrichtung 10 realisiert ist. Im letztgenannten Fall ist der übrige Teil der äußersten Materiallage 2 durch eine oder mehrere Materialmatten 7, 8, beispielsweise aus einem Faserverbundmaterial, gebildet. Optional setzt eine äußere Oberfläche 10a der Sensoreinrichtung 10 eine äußere Oberfläche 7a, 8a der Materialmatten 7, 8 stetig fort, wie dies in Fig. 7 beispielhaft gezeigt ist. Die äußere Oberfläche 10a der Sensoreinrichtung 10 bildet damit einen Teil der Oberfläche 2a der äußersten Materiallage 2.

Wie in den Fig. 1 und 7 beispielhaft dargestellt ist, kann die Sensoreinrichtung 10, die nicht Teil der Erfindung ist, eine einzige Sensoreinheit 11 aufweisen. In Fig. 1 ist die Sensoreinheit 11 als flächiger Zuschnitt ausgebildet, welcher die gesamte äußerste Materiallage 2 bildet. In Fig. 7 ist die Sensoreinheit 11 bandförmig, also als Sensorband realisiert. Ein solches Sensorband kann beispielsweise eine Breite b11 aufweisen, die maximal 50 Prozent einer Länge l11 des Sensorbands beträgt, insbesondere maximal 20 Prozent und bevorzugt maximal 10 Prozent der Länge l11 des Sensorbands.

Wie in Fig. 8 gezeigt ist, ist gemäß der vorliegenden Erfindung vorgesehen, dass die Sensoreinrichtung 10 mehrere Sensoreinheiten 11 aufweist. In Fig. 8 sind die Sensoreinheiten 11 ebenfalls bandförmig ausgebildet. Weiterhin ist auch in Fig. 8 die gesamte äußerste Materiallage 2 durch die Sensoreinrichtung 10 ausgebildet. Hierzu ist eine Vielzahl von bandförmigen Sensoreinheiten 11 nebeneinander angeordnet. In Fig. 8 ist durch gestrichelte Linien ferner dargestellt, dass zusätzlich zu der äußersten Materiallage 2 auch eine sich in der Dickenrichtung D an die äußerste Materiallage 2 anschließende erste innere Materiallage 3 zumindest bereichsweise durch die Sensoreinrichtung 10 gebildet sein kann. Beispielsweise kann auch die in Fig. 1 durch das Bezugszeichen 3 gekennzeichnete Materiallage ganz oder teilweise durch die Sensoreinrichtung 10 realisiert sein. Wie in Fig. 8 beispielhaft gezeigt ist, kann hierzu ein Teil der ersten inneren Materiallage 3 ebenfalls zumindest eine Sensoreinheit 11 enthalten. In Fig. 8 ist beispielhaft gezeigt, dass die ersten inneren Materiallage 3 drei bandförmige Sensoreinheiten 11 aufweist, die jeweils in gestrichelten Linien dargestellt sind und beabstandet zueinander angeordnet sind. Selbstverständlich kann auch die gesamte erste innere Materiallage 3 durch eine einzige Sensoreinheit 11 oder durch eine Vielzahl von bandförmigen Sensoreinheiten 11 gebildet sein. Allgemein kann in der ersten inneren Materiallage 3 zumindest eine Sensoreinheit 11 vorgesehen sein.

Wie in Fig. 8 außerdem gezeigt ist, ist optional vorgesehen, dass die in der äußersten Materiallage 2 und die in der ersten inneren Materiallage 3 angeordneten bandförmig Sensoreinheiten 11 sich quer zueinander erstrecken, also entlang quer zueinander stehenden Richtungen R1, R2 verlaufen.

Fig. 9 zeigt beispielhaft ein als Profilträger realisiertes Strukturbauteil 1. Das in Fig. 9 beispielhaft gezeigte Strukturbauteil 1 weist einen T-förmigen Querschnitt auf und kann beispielsweise als ein Stringer in einem Luftfahrzeug 100 verwendet werden. Wie in Fig. 9 weiterhin gezeigt ist, kann die Sensoreinrichtung 10 lediglich einen Teilbereich der äußersten Materiallage 2 des Strukturbauteils 1 ausbilden und beispielsweise in Bezug auf eine Längserstreckung des Strukturbauteils 1 in einem mittleren Bereich angeordnet sein. Dies ist vorteilhaft, da in diesem Bereich typischerweise die stärksten Verformungen auftreten. Allgemein kann die Sensoreinrichtung 10 in einem Bereich des Strukturbauteils 1 angeordnet sein, in welchem starke Verformungen erwartet werden und welcher damit anfällig für Beschädigungen ist.

Mittels einem anhand der Fig. 1, 7, 8 und 9 beschriebenen Strukturbauteil 1 lässt sich in einfacher Weise ein System 50 zur Detektion von Beschädigungen B, wie einer Delamination der äußersten Materialschicht 2, realisieren. Fig. 2 zeigt schematisch ein solches System 50, das neben dem Strukturbauteil 1 zumindest eine Spannungsmesseinrichtung 51 sowie optional eine Verformungserfassungseinrichtung 52, wie z.B. einen Dehnmessstreifen, aufweist.

Wie in Fig. 6 erkennbar ist, ist die Spannungsmesseinrichtung 51 an die Elektroden 12, 13 der Sensoreinheit 11 angeschlossen, um eine zwischen den Elektroden 12, 13 vorliegende elektrische Spannung U zu messen. Erfindungsgemäß weist die Sensoreinrichtung 10 mehrere Sensoreinheiten 11 auf, wie in Fig. 8, und eine der Anzahl der Sensoreinheiten 11 entsprechende Anzahl von Spannungsmesseinrichtungen 51 ist vorgesehen. Erfindungsgemäß ist je eine Spannungsmesseinrichtung 51 an die Elektroden 12, 13 jeweils einer Sensoreinheit 11 angeschlossen.

Die optionale Verformungserfassungseinrichtung 52 ist an dem Strukturbauteil 1 angeordnet. Wie in Fig. 2 beispielhaft gezeigt ist, kann die Verformungserfassungseinrichtung 52 insbesondere an der äußeren Oberfläche 2a der äußersten Materiallage 2 des Strukturbauteils 1 angeordnet sein.

Mittels dieses Systems 2 ist eine Beschädigung B des Strukturbauteils 1 detektierbar. In Fig. 2 ist das Strukturbauteil 1 in einem ersten Verformungszustand gezeigt, wobei in Fig. 2 beispielhaft ein flächige Biegung als Verformungszustand dargestellt ist. Um diesen beispielhaft gezeigten Verformungszustand herzustellen, wurde das Strukturbauteil 1 mit einem Biegemoment beaufschlagt. Durch die Verformung des Strukturbauteils werden Scherkräfte bzw. Scherspannungen entlang der Grenzflächen 20 der Materiallagen 2, 3, 4, 5, 6 erzeugt.

Fig. 3 zeigt schematisch und beispielhaft den zeitlichen Verlauf einer an den Elektroden 12, 13 einer Sensoreinheit 11 der Sensoreinrichtung 10 mittels der Spannungsmesseinrichtung 51 ermittelten elektrischen Spannung U, der sich ergibt, wenn das Strukturbauteil 1 von einem Ausgangszustand in den ersten Verformungszustand und wieder zurück verformt wird. Dieser Spannungsverlauf V ist für einen vorbestimmten Zeitraum T in Fig. 3 als volle Linie dargestellt. In Fig. 3 ist über den vorbestimmten Zeitraum T als gestrichelte Linie außerdem der Verlauf eines Maßes E für die Verformung des Strukturbauteils 1 dargestellt. Dieser Verformungsverlauf E ist als gestrichelte Linie dargestellt. Als Maß E für die Verformung kann beispielsweise eine mittels des optionalen Dehnmessstreifens 52 erfasste Dehnung der äußersten Materialschicht 2 dienen.

Wie in Fig. 2 erkennbar ist, tritt durch die Verformung des Strukturbauteils 1 in den ersten Verformungszustand keine Beschädigung auf. Durch die Verformung des Strukturbauteils 1 wird die äußerste Materialschicht 2 verformt und im Beispiel der Fig. 2 insbesondere gestaucht bzw. komprimiert. Dies ist, in Fig. 3 durch eine Abnahme der Dehnung E erkennbar. Ferner führt die Verformung der äußersten Materialschicht 2 zu einer Verformung der Sensoreinheit 11 und damit zu einer Änderung der zwischen den Elektroden 12, 13 gemessenen Spannung U. In Fig. 3 ist beispielhaft eine Abnahme der gemessenen Spannung U über die Zeit mit zunehmender Verformung E dargestellt (sowohl die Dehnung als auch die Spannung U nehmen ab). Wenn keine Beschädigung B vorliegt, kehrt das Strukturbauteil 1 durch Verringerung der wirkenden mechanischen Belastung wieder in seinen Ausgangszustand zurück. Das heißt, die Verformung E wird mit der Zeit wieder Verringert. Dies ist in Fig. 3 aufgrund der Verringerung der Stauchung der äußersten Materiallage 2 durch eine Zunahme der Dehnung E erkennbar. Die gemessene Spannung U an den Elektroden 12, 13 kehrt ebenfalls entsprechend zum Ausgangswert zurück.

In Fig. 4 ist beispielhaft ein zweiter Verformungszustand des Strukturbauteils 1 gezeigt, in welchem eine Beschädigung B in Form einer Delamination der äußersten Materiallage 2 von der ersten inneren Materiallage 3 vorliegt. Wie in Fig. 4 erkennbar, ist die äußerste Materiallage 2, welche zumindest teilweise von der Sensoreinrichtung 10 gebildet ist, infolge der Verformung teilweise von der darunter liegenden Materiallage 3 getrennt. Es wurde also zumindest teilweise die mechanische Verbindung zweier benachbarter Materiallagen 2, 3 aufgehoben, was als Delamination bezeichnet wird. Dementsprechend entspricht die Verformung der äußerste Materiallage 2 nicht mehr vollständig derjenigen der weiteren Materiallagen 3, 4, 5, 6 des Strukturbauteils 1.

Das Auftreten einer Beschädigung 2 kann mithilfe der Sensoreinrichtung 10 detektiert werden, indem mittels der Spannungsmesseinrichtung 51 über einen vorbestimmten Zeitraum T die an sich zwischen den Elektroden 12, 13 der Sensoreinheit 11 einstellende elektrische Spannung U erfasst wird und der sich ergebende zeitliche Spannungsverlauf V. Optional wird zusätzlich auch der zeitliche Verformungsverlauf E wie oben beschrieben mittels des Dehnmessstreifens 52 erfasst.

Fig. 5 zeigt schematisch den über einen vorbestimmten Zeitraum T erfassten Spannungsverlauf V und den Verformungsverlauf E, der sich bei einer zweimal nacheinander ausgeführten Verformung des Strukturbauteils 1 in den in Fig. 4 gezeigten Verformungszustand ergibt, wenn während der erstmaligen Verformung eine Beschädigung B in Form einer Delamination auftritt.

In Fig. 5 ist zu erkennen, dass das Strukturbauteil 1 während eines ersten Teilzeitraums T1 bis in den in Fig. 4 gezeigten Zustand verformt wird. Die mittels des Dehnmessstreifens 52 erfasst Dehnung nimmt stetig ab, da die äußerste Materialschicht 2 durch die Verformung gestaucht wird. Diese Stauchung führt gleichzeitig zu einer Abnahme der Spannung U bis zu einem Zeitpunkt t_{B}, an welchem die Beschädigung B eintritt. Infolge der Delamination wird die Stauchung der äußeren Materialschicht 2 verringert und damit auch die Stauchung bzw. Verformung des EAP 14 der Sensoreinheit 11. Dies führt vorliegend zu einer Zunahme der Spannung U, obwohl das Strukturbauteil 1 weiter Verformt wird, wie durch die weitere Abnahme der Dehnung E in Fig. 5 erkennbar ist.

Somit kann der Spannungsverlauf V auf eine Änderung des Spannungsverlaufs V analysiert werden, was ein Beispiel für ein Vorliegen eines eine Beschädigung B kennzeichnenden Beschädigungskriteriums darstellt. Ein weiteres Beschädigungskriterium, dessen Vorliegen durch Analyse des Spannungsverlaufs V und des Verformungsverlaufs E ermittelbar ist, ist außerdem durch eine Änderung des Spannungsverlaufs V im Vergleich dem Verformungsverlauf E des Strukturbauteils 1 gegeben, beispielsweise dann, wenn ein Betrag der Differenz des zeitlichen Gradienten des Verformungsverlaufs E und des zeitlichen Gradienten des Spannungsverlaufs V außerhalb einen vorbestimmten Grenzwert erreicht oder übersteigt.

Die Analyse umfasst allgemein die Erkennung eines Verlaufsmusters in dem Spannungsverlauf V als Beschädigungskriterium und kann beispielsweise mit Hilfe einer Auswertungseinrichtung 53 erfolgen. Die Auswertungseinrichtung 53 kann beispielsweise einen Prozessor und einen Speicher, auf dem eine Auswertungssoftware gespeichert ist, aufweisen.

Wie in Fig. 5 weiter anhand des Verformungsverlaufs E erkennbar ist, erfolgt während eines zweiten, späteren Zeitraums T2 eine Verformung des Strukturbauteils 1 zurück in dessen Ausgangszustand und erneut in den in Fig. 4 beispielhaft gezeigten zweiten Verformungszustand. Wie in Fig. 5 erkennbar, ändert sich die erfasste Spannung U trotz Verformung des Strukturbauteils 1 nur noch in geringerem Umfang als dies während des ersten Teilzeitraums T1 bis zum Zeitpunkt t_{B} der Fall war. Damit ist ein weiteres Beschädigungskriterium durch eine Abweichung des Spannungsverlaufs V in dem ersten Teilzeitraum T1 von dem Spannungsverlauf V in einem zweiten, späteren Teilzeitraum T2 gegeben.

Vor diesem Hintergrund wird erneut auf Fig. 8 Bezug genommen, in welcher eine Beschädigung B durch einen gestrichelten Kreis symbolisch dargestellt ist. Wenn diese Beschädigung B während einer Verformung des Strukturbauteils 1 auftritt, wird sowohl über die Elektroden 12, 13 der Sensoreinheit 11A, die einen Teil der äußersten Materialschicht 2 bildet, als auch über die Elektroden 12, 13 der Sensoreinheit 11B, die einen Teil der ersten inneren Materialschicht 3 bildet, über die entsprechenden Spannungsmesseinrichtungen 51 eine Änderung des Spannungsverlaufs V aufgezeichnet. In dem aufgezeichneten Spannungsverlauf der Sensoreinheiten 11A, 11B liegt also ein Beschädigungskriterium vor. Durch die Erstreckung der als Bänder realisierten Sensoreinheiten 11A, 11B quer zueinander ergeben sich geometrische Überlappungsbereiche der Sensoreinheiten 11A, 11B. Dadurch kann die Beschädigung B als in diesem Überlappungsbereich liegend lokalisiert werden.

Fig. 12 zeigt schematisch ein Luftfahrzeug 100, welches das System 50 zur Detektion von Beschädigungen aufweist. Das Strukturbauteil 1 ist hier beispielhaft als ein Hautsegment einer Außenhaut des Luftfahrzeugs dargestellt. Die Spannungsmesseinrichtung 51 ist lediglich schematisch als Block dargestellt.

### BEZUGSZEICHENLISTE

- 1: Strukturbauteil
- 2: äußerste Materiallage
- 2a: Oberfläche der äußersten Materiallage
- 3-6: Materiallagen
- 7,8: Materialmatten
- 7a, 8a: Oberflächen der Materialmatten
- 10: Sensoreinrichtung
- 10a: äußere Oberfläche der Sensoreinrichtung
- 11: Sensoreinheit
- 12, 13: Elektroden der Sensoreinheit
- 14: elektroaktives Polymer
- 15: elektrische Spannungsquelle
- 20: Grenzflächen der Materiallagen
- 50: System
- 51: Spannungsmesseinrichtung
- 52: Verformungserfassungseinrichtung
- 53: Auswertungseinrichtung
- B: Beschädigung
- D: Dickenrichtung
- E: Verlauf einer Verformung des Strukturbauteils
- E: Dehnung
- R1: erste Richtung
- R2: zweite Richtung
- t: Zeit
- t_{B}: Zeitpunkt der Beschädigung
- T: vorbestimmter Zeitraum
- T1: erster Teilzeitraum
- T2: zweiter, späterer Teilzeitraum
- U: elektrische Spannung
- V: Spannungsverlauf

## Patentansprüche

1. Strukturbauteil (1) mit einer Vielzahl von Materiallagen (2; 3; 4; 5; 6), welche in einer Dickenrichtung (D) gestapelt angeordnet und miteinander verbunden sind;
wobei zumindest eine der Materiallagen (3; 4; 5; 6) eine Faserverbundschicht aus einem Faserverbundmaterial ist, welche durch Faserbänder realisiert ist;
wobei eine in Bezug auf die Dickenrichtung (D) äußerste Materiallage (2) zumindest abschnittsweise durch eine Sensoreinrichtung (10) ausgebildet ist, welche mehrere nebeneinander angeordnete bandförmige Sensoreinheiten (11) aufweist, wobei je eine Sensoreinheit (11) ein zwischen elektrisch leitfähigen Elektroden (12; 13) angeordnetes elektroaktives Polymer (14) aufweist.

2. Strukturbauteil (1) nach Anspruch 1, wobei die Sensoreinrichtung (10) die äußerste Materiallage (2) vollflächig ausbildet.

3. Strukturbauteil (1) nach einem der voranstehenden Ansprüche, wobei zusätzlich zu der äußersten Materiallage (2) auch eine sich in der Dickenrichtung (D) an die äußerste Materiallage (2) anschließende erste innere Materiallage (3) zumindest abschnittsweise durch die Sensoreinrichtung (10) ausgebildet ist.

4. Strukturbauteil (1) nach Anspruch 3, wobei in der ersten inneren Materiallage (3) zumindest eine Sensoreinheit (11) vorgesehen ist.

5. Strukturbauteil (1) nach Anspruch 4, wobei die in der äußersten Materiallage (2) und die in der ersten inneren Materiallage (3) angeordneten bandförmigen Sensoreinheiten (11) sich quer zueinander erstrecken.

6. Strukturbauteil (1) nach einem der voranstehenden Ansprüche, wobei das elektroaktive Polymer (14) ein dielektrisches elektroaktives Polymer ist, insbesondere ein thermoplastisches Polyurethan-Elastomer.

7. Strukturbauteil (1) nach einem der voranstehenden Ansprüche, wobei die Elektroden (12; 13) der Sensoreinheiten (11) aus einem elektrisch leitfähigen Polymer gebildet sind.

8. System (50) zur Detektion von Beschädigungen (B), mit einem Strukturbauteil (1) gemäß einem der voranstehenden Ansprüche und Spannungsmesseinrichtungen (51),
wobei je eine Spannungsmesseinrichtung (51) an die Elektroden (12; 13) jeweils einer Sensoreinheit (11) angeschlossen ist, um eine zwischen den Elektroden (12; 13) vorliegende elektrische Spannung (U) zu messen.

9. System (50) nach Anspruch 8, wobei an dem Strukturbauteil (1) zusätzlich eine Verformungserfassungseinrichtung (52) zur Erfassung einer Verformung des Strukturbauteils (1) angeordnet ist.

10. Luftfahrzeug (100) mit einem System (50) nach einem der Ansprüche 8 bis 9.

11. Verfahren zur Detektion von Beschädigungen (B) eines Strukturbauteils (1) gemäß einem der Ansprüche 1 bis 7, mit folgenden Verfahrensschritten:
Erzeugen von Scherkräften entlang von Grenzflächen (20) der Materiallagen (2; 3; 4; 5; 6) durch mechanisches Verformen des Strukturbauteils (1);
Erfassen einer elektrischen Spannung (U) an den Elektroden (12; 13) der Sensoreinheiten (11) der Sensoreinrichtung (10) über einen vorbestimmten Zeitraum (T); und
Analyse eines sich über den vorbestimmten Zeitraum (T) ergebenden Verlaufs (V) der elektrischen Spannung (U) hinsichtlich des Vorliegens eines eine Beschädigung (B) kennzeichnenden Beschädigungskriteriums.

12. Verfahren nach Anspruch 11, wobei das Beschädigungskriterium erfüllt ist
durch eine Änderung des Spannungsverlaufs (V), durch eine Änderung des Spannungsverlaufs (V) im Vergleich zu einem über den vorbestimmten Zeitraum (T) erfassten Verlauf (E) einer Verformung des Strukturbauteils (1) oder durch eine Abweichung des Spannungsverlaufs (V) in einem ersten Teilzeitraum (T1) des vorbestimmten Zeitraums (T) von dem Spannungsverlauf (V) in einem zweiten, späteren Teilzeitraum (T2) des vorbestimmten Zeitraums.

## Claims

1. Structural component (1) having a multiplicity of material layers (2; 3; 4; 5; 6), which are stacked and connected together in a thickness direction (D); wherein at least one of the material layers (3; 4; 5; 6) is a fibre composite layer composed of a fibre composite material, said fibre composite layer being realized by way of fibre bands;
wherein an outermost material layer (2) in relation to the thickness direction (D) is formed by a sensor device (10) at least in sections, said sensor device having a plurality of band-like sensor units (11) arranged alongside one another, wherein each sensor unit (11) comprises an electroactive polymer (14) arranged between electrically conductive electrodes (12; 13).

2. Structural component (1) according to Claim 1, wherein the sensor device (10) forms the outermost material layer (2) in a full-area manner.

3. Structural component (1) according to one of the preceding claims, wherein in addition to the outermost material layer (2), a first inner material layer (3) adjoining the outermost material layer (2) in the thickness direction (D) is also formed by the sensor device (10) at least in sections.

4. Structural component (1) according to Claim 3, wherein at least one sensor unit (11) is provided in the first inner material layer (3).

5. Structural component (1) according to Claim 4, wherein the band-like sensor units (11) arranged in the outermost material layer (2) and those arranged in the first inner material layer (3) extend transversely with respect to one other.

6. Structural component (1) according to one of the preceding claims, wherein the electroactive polymer (14) is a dielectric electroactive polymer, in particular a thermoplastic polyurethane elastomer.

7. Structural component (1) according to one of the preceding claims, wherein the electrodes (12; 13) of the sensor units (11) are formed from an electrically conductive polymer.

8. System (50) for the detection of damage (B), having a structural component (1) according to one of the preceding claims and voltage measuring devices (51), wherein each voltage measuring device (51) is connected to the electrodes (12; 13) of a respective sensor unit (11), in order to measure an electrical voltage (U) present between the electrodes (12; 13).

9. System (50) according to Claim 8, wherein a deformation detecting device (52) for detecting deformation of the structural component (1) is additionally arranged on the structural component (1) .

10. Aircraft (100) having a system (50) according to one of Claims 8 to 9.

11. Method for the detection of damage (B) of a structural component (1) according to one of Claims 1 to 7, having the following method steps of:
generating shear forces along boundary surfaces (20) of the material layers (2; 3; 4; 5; 6) by mechanical deformation of the structural component (1);
detecting an electrical voltage (U) at the electrodes (12; 13) of the sensor units (11) of the sensor device (10) over a predetermined period of time (T); and
analysing a curve (V) of the electrical voltage (U) that arises over the predetermined period of time (T) in regard to the existence of a damage criterion indicative of damage (B).

12. Method according to Claim 11, wherein the damage criterion is fulfilled by a change in the voltage curve (V), by a change in the voltage curve (V) in comparison to a deformation profile (E) of the structural component (1) that is detected over the predetermined period of time (T), or by a deviation of the voltage curve (V) in a first partial period of time (Tl) of the predetermined period of time (T) from the voltage curve (V) in a second, later partial period of time (T2) of the predetermined period of time.

## Revendications

1. Composant structurel (1) comprenant une pluralité de couches de matériau (2 ; 3 ; 4 ; 5 ; 6) qui sont disposées de manière empilée dans la direction de l'épaisseur (D) et qui sont reliées les unes aux autres ;
au moins une des couches de matériau (3 ; 4 ; 5 ; 6) étant une couche composite fibreuse en matériau composite fibreux qui est réalisée par des bandes de fibres ;
une couche de matériau (2), qui est la plus extérieure par rapport à la direction de l'épaisseur (D), étant formée au moins par portions par un dispositif capteur (10) qui comporte une pluralité d'unités formant capteur (11) en forme de bande qui sont disposées les unes à côté des autres, chaque unité formant capteur (11) comportant un polymère électroactif (14) disposé entre des électrodes électriquement conductrices (12 ; 13) .

2. Composant structurel (1) selon la revendication 1, le dispositif capteur (10) formant sur toute la surface la couche de matériau la plus extérieure (2).

3. Composant structurel (1) selon l'une des revendications précédentes, en plus de la couche de matériau la plus extérieure (2), une première couche de matériau intérieure (3) adjacente à la couche de matériau la plus extérieure (2) dans la direction de l'épaisseur (D) étant également formée au moins par portions par le dispositif capteur (10).

4. Composant structurel (1) selon la revendication 3, au moins une unité formant capteur (11) étant prévue dans la première couche de matériau intérieure (3).

5. Composant structurel (1) selon la revendication 4, les unités formant capteur (11) en forme de bande, qui sont disposées dans la couche de matériau la plus extérieure (2) et dans la première couche de matériau intérieure (3), s'étendant transversalement les unes aux autres.

6. Composant structurel (1) selon l'une des revendications précédentes, le polymère électroactif (14) étant un polymère électroactif diélectrique, notamment un élastomère de polyuréthane thermoplastique.

7. Composant structurel (1) selon l'une des revendications précédentes, les électrodes (12 ; 13) des unités formant capteurs (11) étant formées à partir d'un polymère électriquement conducteur.

8. Système (50) de détection de dommages (B), ledit système comprenant un élément structurel (1) selon l'une des revendications précédentes et des dispositifs de mesure de tension (51), chaque dispositif de mesure de tension (51) étant raccordé aux électrodes (12 ; 13) d'une unité formant capteur (11) afin de mesurer une tension électrique (U) entre les électrodes (12 ; 13).

9. Système (50) selon la revendication 8, un dispositif de détection de déformation (52) destiné à détecter une déformation du composant structurel (1) étant en outre disposé au niveau du composant structurel (1).

10. Aéronef (100) comprenant un système (50) selon l'une des revendications 8 à 9.

11. Procédé de détection de dommages (B) d'un composant structurel (1) selon l'une des revendications 1 à 7, le procédé comprenant les étapes suivantes : générer des forces de cisaillement le long de surfaces limites (20) des couches de matériau (2 ; 3 ; 4 ; 5 ; 6) par déformation mécanique du composant structurel (1) ;
détecter une tension électrique (U) au niveau des électrodes (12 ; 13) des unités formant capteurs (11) du dispositif capteur (10) sur une période prédéterminée (T) ; et
analyser une courbe résultante (V) de la tension électrique (U) sur la période prédéterminée (T) quant à la présence d'un critère de dommage caractérisant un dommage (B).

12. Procédé selon la revendication 11, le critère de dommages étant rempli par une variation de la courbe de tension (V), par une variation de la courbe de tension (V) par rapport à une courbe (E), détectée sur la période prédéterminée (T), d'une déformation du composant structurel (1) ou par un écart de la courbe de tension (V) dans une première sous-période (T1) de la période prédéterminée (T) par rapport à la courbe de tension (V) dans une deuxième sous-période ultérieure (T2) de la période prédéterminée.
